# EUROPEAN PATENT APPLICATION

(11) **EP 3 435 749 A1**
(43) Date of publication of application: **30.01.2019**
(21) Application number: 17183787.5
(22) Date of filing: 28.07.2017
(51) Int. Cl.: H05K 7/14

(54) **FLEXIBLE ARCHITECTURE ELECTRONIC CONTROL UNIT**

(71) Applicant: Yazaki Europe Ltd, Hertfordshire HP2 7SJ (GB)
(72) Inventor: THEODORESCU, Sorin G., 42799 Leichlingen (DE); SILVIO, Ralph, 42279 Wuppertal (DE)
(74) Representative: Neumann Müller Oberwalleney & Partner Patentanwälte

(57) **Abstract**

Modular electronic control device comprising a main circuit board with a plurality of module connectors for plug-in modules and with a plurality of system connectors, the system connectors providing a physical interface of the control device, and a plurality of plug-in modules mounted detachably to the main circuit board via the module connectors, and comprising an internal interface for exchanging signals with at least one other plug-in module; and method of operating such a modular electronic control device.

## Description

The invention refers to a modular electronic control device comprising a main circuit board with a plurality of module connectors for plug-in modules and with a plurality of system connectors, the system connectors providing a physical interface of the control device, and a plurality of plug-in modules mounted detachably to the main circuit board via the module connectors, and comprising an internal interface for exchanging signals with at least one other plug-in module; the invention refers further to a method of operating such a modular electronic control device.

Electronic control devices of the described kind are used for power distribution and actuator control, for example in automotive applications, typically using embedded controllers, which are devices with internal computing capability, based, for example, on complex microcontrollers. In the automotive technology those devices are often referred to as ECUs, which is an abbreviation for Electronic Control Units, which commonly comprise a single Printed Circuit Board, or PCB, with a fixed number of signal inputs and/or outputs, a predefined circuit configuration and statically allocated signal functions.

US Patent No. 7 137 823 B2 refers to an apparatus, comprising a plurality of electronic control units, each of which is configured to control electronic components in a vehicle, and is provided with a plurality of first terminals classified into a plurality of groups each of which is associated with electronic components in one of sections in the vehicle. A board, having a first face on which the electronic control units are mounted is disclosed, and a plurality of first connectors, provided on a second face of the board, which is opposite to the first face, each of the first connectors having second terminals each of which is electrically connected to at least one of the first terminals in one of the groups in one of the electronic control units, wherein all of the second terminals in one of the first connectors are electrically connected to a wire harness extended to one of the sections in the vehicle. The wire harness connectivity and branching needed are reduced in their mechanical complexity. However, the structures of the ECU are fixed and a customization of an ECU itself may only be achieved by exchanging the respective ECU with a different unit.

It is thus an objective of the invention to provide an electronic control device with a flexible architecture, which allows a customization of the electronic control functionality.

The objective is achieved by a modular electronic control device, which comprises a main circuit board with a plurality of module connectors for plug-in modules and with a plurality of system connectors providing an external interface of the control device. The modular electronic control device further comprises a plurality of plug-in modules mounted detachably to the main circuit board via the module connectors, and comprising an internal interface for exchanging signals with at least one other plug-in module. According to the invention, the plurality of plug-in modules is composed of at least two classes of plug-in modules and at least one of the classes is composed of at least two types of plug-in modules, wherein the different types of plug-in modules per class are exchangeable only within that class and wherein a structure and a functionality of the control device depends upon the types and the number of plug-in modules connected to the main circuit board.

An advantage of this modular electronic control device is to provide a more flexible design, which can be implemented in various application fields, including, but not limited to, the automotive one. The flexible modular structure of the described ECU advantageously provides a customizable functionality, which is implemented with the interconnected plug-in modules that contain, for example, functional blocks on separate PCBs with possible configurable circuitry. The structure of the electronic control device is particularly customized by choosing the respective plug-in modules, which may be done at OEM level. The operation of the electronic control device may preferably be configurable using different classes and types of plug-in modules.

The modular electronic control device further beneficially provides the ability to easily exchange or add generic functional blocks for communication and input/output ports, adaptable signal assignment, wherein types of input may be digital, analogue, pulse-width-modulation (PWM) or frequency, and wherein types of output may be High side, Low side, PWM, frequency and analogue. The flexibility advantageously shortens product development cycles and streamlines validation processes in respect of products and designs.

According to a preferred embodiment, at least one of the classes comprises types of plug-in modules, wherein exchanging the plug-in module of one type with a plug-in module of the other type will upgrade or downgrade the plug-in module, in order to enable the plug-in module to perform a more or, respectively, a less complex functionality. That allows, for example, easier scalability and upgradability of the electronic control device according to the embodiment. Operational range options for functional upgrades are easily adapted.

According to a further preferred embodiment, one of the classes comprises types of controller plug-in modules with data processing and data storing capability, wherein at least one of the controller plug-in modules is mounted to the main circuit board. Furthermore preferably, other classes of plug-in modules comprise a module circuitry for performing a pre-defined operation. Furthermore preferably, the class of controller plug-in modules comprises at least one of a processor core, a data storage, and/or a programmable logic device. According to a yet further preferred embodiment, each plug-in module comprises a unique identifier, the controller plug-in module being adapted to read the identifier of each connected plug-in module and to determine a structure of the control device from the classes, the types and the number of plug-in modules connected to the main circuit board. In the sense of the invention, the processor is to be understood broadly as a computing entity of any kind. The controller plug-in module may thus include any practical architecture implementations that exist at the moment, like, for example a microcontroller unit (MCU), a microprocessor unit (MPU), a central processor unit (CPU), a digital signal processor (DSP), a graphics processing unit (GPU), and processor cores implemented in an application-specific integrated circuit (ASIC) and/or a field programmable gate array (FPGA).

Advantageously, the described embodiment of the modular electronic control device is capable of a certain self-awareness, i.e. it is adapted to perform functional integrity monitoring and diagnostic on a lower level, implementing local decisions, and reporting to a higher level in regard of system decisions. This capability implements beneficially a configuration management and security features by detecting the modular electronic control device's customized structure in regard of the classes, types and/or number of fitted plug-in modules and by detecting the presence of each plug-in module. As part of the invention, the modular electronic control device behaviour automatically adapts to the detected capabilities. For example, an input/output (I/O) functionality can change, the reaction based on a failure detection, i.e. diagnostic signals, can be different, or the communication sent to other devices in a higher system can be modified. The self-awareness and adaptable operation features allow the modular electronic control device to make local decisions and also be monitored by a supervising ECU in a higher system. That defines a desirably safe environment for plug-in module exchanges for scalable configuration upgrades. Preferably, at least one class comprises plug-in modules with a dynamically adaptable functionality, subject to the detected structure of the control device.

According to a yet further preferred embodiment, a main board circuitry provides first signal connections interconnecting the module connectors and second signal connections connecting each system connector to at least one module connector, wherein each module connector is adapted to electrically and/or mechanically match with only one corresponding class of plug-in modules. Preferably the main board circuitry provides a power network, wherein the module connectors are connected to the power network.

According to a yet further preferred embodiment, at least one class comprises plug-in modules for exchanging signals via one of the system connectors, thus providing the external interface of the control device. It has to be understood, however, that this class of plug-in modules enables the modular electronic control device to communicate via the system connectors, by the respective design of the plug-in modules of this class. Generally, the plug-in modules aim to communicate only with the main circuit board subsystem, but, depending on the particular application, the main circuit board implementation routes certain internal interfaces to the external system connectors. According to a yet further preferred embodiment, the module circuitry for performing a pre-defined operation of at least one class of plug-in modules is configurable, wherein the type of each plug-in module of that class is defined by a respective configuration of the plug-in module.

According to a yet further preferred embodiment, at least one class of plug-in modules comprises a data memory, wherein the type of each plug-in module of that class is defined by at least one of a kind, a size and a purpose of the data memory.

According to a yet further preferred embodiment, one class of plug-in modules consists of input/output plug-in modules for enabling an exchange of signals via one of the system connectors, the module circuitry forming a functional block being adapted to perform at least one of the following kinds of operations: digital input, digital output, analogue input, analogue output, the kind of operation defining the respective type of input/output plug-in module.

Alternatively or additionally, a preferred embodiment comprises one class of plug-in modules for each of the following kinds of operations: digital input, digital output, analogue input, analogue output, wherein each of the classes comprises plug-in modules of one or more types, the respective type depending on an operation and/or configuration of the plug-in module.

Particularly preferable, one class of plug-in modules consists of digital input plug-in modules for enabling a receipt of digital data via one of the system connectors, the module circuitry forming a functional block being adapted to perform digital input operations, the respective type of digital input plug-in module being defined by at least one of a number of digital input lines and a kind of digital input signal, the kind being one of high voltage, low voltage and pulse width modulation signal.

Furthermore particularly preferable, one class of plug-in modules consists of digital output plug-in modules for enabling an output of digital signals via one of the system connectors, the module circuitry forming a functional block being adapted to perform digital output operations, the respective type of digital output plug-in module being defined by at least one of a number of digital output lines and a kind of digital output signal, the kind being one of high voltage, low voltage and pulse width modulation signal.

Furthermore particularly preferable, one class of plug-in modules consists of analogue input plug-in modules for enabling a receipt of analogue signals via one of the system connectors, the module circuitry forming a functional block being adapted to perform analogue input operations, the respective type of analogue input plug-in module being defined by at least one of a number of analogue input lines and a kind of analogue input signal.

Furthermore particularly preferable, one class of plug-in modules consists of analogue output plug-in modules for enabling an output of analogue signals via one of the system connectors, the module circuitry forming a functional block being adapted to perform analogue output operations, the respective type of analogue output plug-in module being defined by at least one of a number of analogue output lines and a kind of analogue output signal.

According to a particularly preferred embodiment, the functional block for digital input supports signal conditioning and diagnostic for digital and pulse width modulated inputs, wherein the functional block for analogue input provides signal conditioning and diagnostic for analogue inputs, wherein the functional block for analogue output provides driving capability and diagnostic for analogue load outputs, wherein the functional block for digital output supports at least one of the following digital outputs: high side, low side, half bridge, full bridge and pulse width modulation, and provides respective driving capabilities and diagnostic.

According to a yet further preferred embodiment, another class of plug-in modules consists of communication plug-in modules for enabling a communication via one of the system connectors, for example to a superordinate system, preferably via a communication bus or a point to point network, whichever the system connector is connected to.

According to a yet further preferred embodiment, another class of plug-in modules consists of power supply unit plug-in modules comprising at least one DC-DC converter for transferring energy from a main power source to the plug-in modules.

According to a yet further preferred embodiment, another class of plug-in modules consists of monitoring plug-in modules comprising at least one functional block for supervising a voltage supply status and quality and monitoring for correct operation of the control device, in particular via a watchdog circuit being adapted to generate a reset if a monitored signal is out of an expected operational range.

Another aspect of the invention refers to a method of operating a modular electronic control device as described herein before, wherein the plurality of plug-in modules is detachably mounted to the main circuit board via the module connectors, wherein each plug-in module sends its unique identifier via the internal interface for exchanging signals to the controller plug-in module, wherein the controller plug-in module reads the identifiers of each connected plug-in module and determines a structure of the control device from the classes, the types and the number of plug-in modules connected to the main circuit board.

According to a preferred embodiment of the method, the controller plug-in module adapts an operating mode of the control device depending on the determined structure of the control device, the operating mode including at least one of an internal communication mode between the plug-in modules and an input/output functionality of the control device.

The invention is further illustrated with respect to a preferred embodiment and the attached drawings. The illustration refers to the modular electronic control device as well, as to the method of operating the modular electronic control device. The exemplary description refers to the preferred embodiment and does not restrict the general inventive idea in any way.

In the Figures
Figure 1 shows schematically an embodiment of the modular electronic control device according to the invention in a block diagram; and
Figure 2 shows schematically an exemplary embodiment of one of the plug-in modules attached to the modular electronic control device and the respective module connector according to Figure 1.

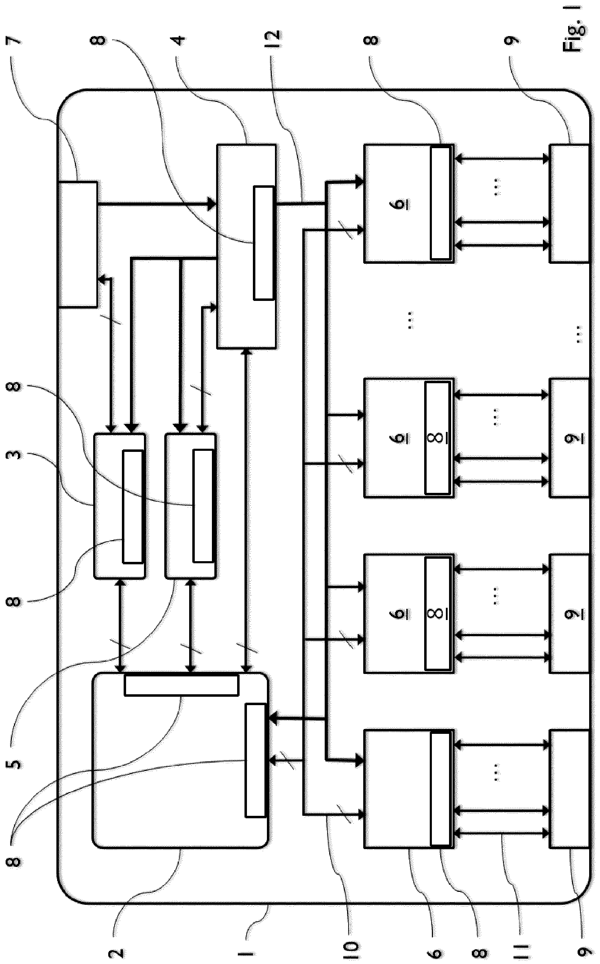

A modular electronic control device according to the invention is schematically depicted in Figure 1. It comprises a main circuit board 1, for example a printed circuit board (PCB) that acts as an interconnect support motherboard or backplane for plug-in modules 2, 3, 4, 5, 6. The main circuit board 1 may include some basic circuitry for auxiliary functions. The number and types of the fitted plug-in modules 2, 3, 4, 5, 6 defines the particular implementation and functionality of the modular electronic control device according to the invention.

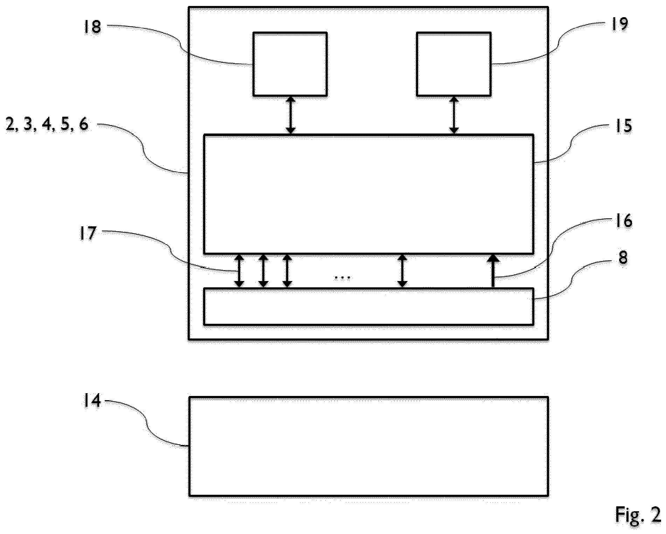

The main circuit board 1 comprises a plurality of module connectors (14, illustrated in Figure 2) for the plug-in modules 2, 3, 4, 5, 6 and a plurality of system connectors 7, 9 providing an external interface of the control device. The plug-in modules 2, 3, 4, 5, 6 are mounted detachably to the main circuit board 1 via the module connectors 14 and have each an internal interface 8 for exchanging signals with a subsystem 10, 11, 12 of the main board 1 to establish a connection to at least one other plug-in module 2, 3, 4, 5, 6. Depending on the particular application, the subsystem 11 of the main board circuitry may be implemented, however, to route certain internal interfaces 8 to the external system connectors 7, 9. The main board 1 subsystem circuitry provides first signal connections 10 interconnecting the module connectors 14 and second signal connections 11 connecting each system connector 7, 9 to at least one module connector 14, wherein each module connector 14 is adapted to electrically and/or mechanically match with only one corresponding class of plug-in modules 2, 3, 4, 5, 6. The main board 1 circuitry subsystem provides a power network 12 to which the module connectors 14 are connected.

The plurality of plug-in modules 2, 3, 4, 5, 6 is composed of at least two classes of plug-in modules and at least one of the classes is composed of at least two types of plug-in modules, wherein the different types of plug-in modules per class are exchangeable only within that class and wherein a structure and a functionality of the control device depends upon the types and the number of plug-in modules 2, 3, 4, 5, 6 connected to the main circuit board 1. At least one of the classes comprises types of plug-in modules 2, 3, 4, 5, 6, wherein the plug-in modules 2, 3, 4, 5, 6 are upgradeable or downgradeable from one type to the other type, in order to perform a more complex functionality, or a less complex functionality. One of the classes comprises types of controller plug-in modules 2 with data processing and data storing capability. At least one of those controller plug-in modules 2 is mounted to the main circuit board 1. The controller plug-in module 2 contains a processor core with oscillator, memories and possible programmable logic circuitry. The microcontroller may be a fixed architecture or implemented in a field-programmable gate array (FPGA) or application-specific integrated circuit (ASIC). A communication plug-in module 3 for enabling a communication of the modular electronic control device via one of the system connectors 7, for example to a superordinate system, preferably via all possible system communication buses (not depicted). A power supply plug-in module 4 provides DC-DC converting capability to transfer electric energy from a system main power source to all internal functional blocks. A supervision and monitoring plug-in module 5 supervises a voltage supply status and quality and monitors a correct operation via a watchdog circuit. It generates a safe reset when the monitored signals are out of the expected operational range. The system connectors 7, 9 are placed on the main board 1 and provide the external interface of the modular electronic control device. In the depicted embodiment, one system connector 7 is adapted to provide a connection to a superordinate system via communication bus, whereas a plurality of system connectors 9 are adapted to provide input and/or output operations in connection with input/output plug-in modules 6, which will be described hereinafter in detail.

The input/output plug-in modules 6 are used to implement I/O functionality of the modular electronic control device, according to the respective dedicated application. The input and/or output channels established in connection with the system connectors 9 as external interfaces and by choice of the appropriate types of input/output plug-in modules 6 may advantageously be configured to control any discrete system, by sending and/or receiving, for example, sensor data and control commands of both analogue or digital origin.

The flexible architecture of the modular electronic control device is defined using the plug-in modules 2, 3, 4, 5, 6 fitted to the main board 1 via the dedicated module connectors 14 to implement the plug-in modules' internal interface 8. The internal interface 8 is preferably standardized for each class. A dedicated module connector 14 allows only plug-in modules of the same class to be fitted. This is advantageous to prevent incorrect plug-in module class placement. For example, the following I/O plug-in module 6 types could be fitted on a specific I/O plug-in module connector 14: analogue input, digital input, analogue output and digital output. This limited compatibility implied by the dedicated module connector 14 and the standardized interface 8 ensures correct configuration and scalability / upgradability. Exchanging the I/O plug-in modules 6 within the same functional class allows the I/O features of the control device to be changed. For example, the following features could be supported. The analogue input plug-in modules 6 could provide signal conditioning for the required analogue inputs, the digital input plug-in modules 6 could support signal conditioning for the required digital and PWM inputs. The analogue output plug-in modules 6 could provide the driving capability and diagnostic for the required analogue load outputs. Digital output plug-in modules 6 could support different High side, Low side, half & full bridge and PWM outputs. They can also have different driving capabilities and diagnostics.

Reference is made now to Figure 2 in connection with Figure 1. In Figure 2, a functional logic representation of an arbitrary plug-in module 2, 3, 4, 5, 6 attached to the modular electronic control device via the respective module connector 14 are illustrated in a diagram. The class and type of plug-in module is defined by an electronic circuitry 15. For the following illustration it is, however, not essential, of which type or class the plug-in module 2, 3, 4, 5, 6 of Figure 2 is. The plug-in module 2, 3, 4, 5, 6 is a pre-defined electronic sub-assembly performing specific functions, which is also referred to as a functional block. The internal interface 8 is the medium for communication with the main board 1 and it is referred to as being internal from a perspective of the modular electronic control unit. The internal interface 8 implies several layers, as a physical layer, i.e. a mechanical interface defined by the type and nature of the connectors used, an electrical layer, i.e. the hardware, defined quantitatively by the electrical parameters range, and an abstract layer for data exchange, including hardware related qualitative signal attributes and conditioning and/or software related commands exchange and communication protocol. Connection lines of the internal interface 8 are dedicated, i.e. routed by the modular electronic control unit for the following three purposes:
- Internal, i.e. towards other plug-in modules 2, 3, 4, 5, 6 via their respective internal interfaces 8, for example to the controller plug-in module 2, used for signal exchange and identification.
- External: towards the system connectors 7, 9, if necessary for the modular electronic control device to communicate with a superordinate system; the external communication functionality is optional for certain plug-in modules, in the depicted embodiment, the communication plug-in module 3 and the input/output plug-in modules 6 provide this external communication functionality.
- Power to supply the electronic circuitry of the plug-in modules 2, 3, 4, 5, 6, as illustrated by arrow 16.

The internal interfaces 8 of the plug-in modules 2, 3, 4, 5, 6 support a specific number of input and/or output signals illustrated by double-pointed arrows 17 and at least the ability to provide a unique identifier 18, which is read by the controller plug-in module 2. The electronic circuitry 15 includes all electronic components of the functional block that perform together the designated functionality. For example, the following functions can be implemented:
- High current driving / switching;
- Signal conditioning, e.g. level adjustment and filtering;
- Protection, monitoring and diagnostic;
- Additional operational flexibility: electrical configurability, redundancy, signal range adjustment.
It may advantageously further be used to partially implement functional safety or electromagnetic compatibility (EMC) related features. The unique identifier 18 is the first particular attribute of the plug-in modules 2, 3, 4, 5, 6 of the modular electronic control unit according to the invention: each plug-in module class has a specific internal interface regarding the physical layer and the electrical layer. It is defined and identified by the unique identifier 18. An identifier encoding system is for example a simple pin matrix or a small serial EEPROM with protected area. A second particular attribute of the plug-in modules 2, 3, 4, 5, 6 of the modular electronic control unit according to the invention is referred to as data 19. Data 19 may be any additional information, which is optionally stored and/or latched as binary data and subsequently made available, for example on request, to the controller plug-in module 2. The data 19 may for example be stored in EEPROM, Flash, RAM, shift register, or flip-flop).

The internal interface 8 provides:
- Connections 17 for low voltage and low current signals that the modular electronic circuit device links to other internal interfaces 8 of other plug-in modules 2, 3, 4, 5, 6.
- Optional connections 17 for higher voltage and higher current signals that the modular electronic circuit device may need to route to the external interfaces with a superordinate system, i.e. to the system connectors 7, 9.
- Connections for Power Supply 16 and ground (GND).

### Bezugszeichenliste

- 1: Main circuit board
- 2: Plug-in module, controller plug-in module class
- 3: Plug-in module, communication plug-in module class
- 4: Plug-in module, power supply unit plug-in module class
- 5: Plug-in module, monitoring plug-in module class
- 6: Plug-in module, input/output plug-in module classes
- 7: System connector
- 8: internal interface
- 9: System connector
- 10: First signal connections
- 11: Second signal connections
- 12: Power network
- 14: Module connector
- 15: Electronic circuitry of the plug-in module
- 16: Arrow, power supply line
- 17: Double-headed arrows, input/output connection lines
- 18: Unique identifier
- 19: Data

## Claims

1. Modular electronic control device comprising:
a main circuit board (1) with a plurality of module connectors for plug-in modules and with a plurality of system connectors, the system connectors (7, 9) providing an external interface of the control device; and
a plurality of plug-in modules (2, 3, 4, 5, 6) mounted detachably to the main circuit board via the module connectors (14), and each plug-in module comprising an internal interface (8) for exchanging signals with at least one other plug-in module;
wherein the plurality of plug-in modules is composed of at least two classes of plug-in modules and at least one of the classes is composed of at least two types of plug-in modules,
wherein the different types of plug-in modules per class are exchangeable only within that class and wherein a structure and a functionality of the control device depends upon the types and the number of plug-in modules connected to the main circuit board.

2. Modular electronic control device according to claim 1, wherein at least one of the classes comprises types of plug-in modules, wherein exchanging the plug-in module (2, 3, 4, 5, 6) of one type with a plug-in module of the other type will upgrade or downgrade the plug-in module, in order to enable the plug-in module to perform a more complex functionality, or, respectively, a less complex functionality.

3. Modular electronic control device according to any one of the preceding claims, wherein one of the classes comprises types of controller plug-in modules (2) with data processing and data storing capability, wherein at least one of the controller plug-in modules is mounted to the main circuit board (1).

4. Modular electronic control device according to any one of the preceding claims, wherein each plug-in module (2, 3, 4, 5, 6) comprises a unique identifier (18), the controller plug-in module (2) being adapted to read the identifier of each connected plug-in module and to determine a structure of the control device from the classes, the types and the number of plug-in modules connected to the main circuit board (1).

5. Modular electronic control device according to any one of the preceding claims, wherein a main board (1) circuitry provides first signal connections (10) interconnecting the module connectors and second signal connections (11) connecting each system connector (7, 9) to at least one module connector (14), wherein each module connector is adapted to electrically and/or mechanically match with only one corresponding class of plug-in modules.

6. Modular electronic control device according to any one of the preceding claims, wherein at least one class comprises plug-in modules (3, 6) for enabling an exchange of signals via one of the system connectors (7, 9).

7. Modular electronic control device according to any one of the preceding claims 4 through 6, wherein an operating mode is adapted subject to the detected structure of the control device.

8. Modular electronic control device according to any one of the preceding claims 4 through 7, wherein at least one class comprises plug-in modules (2, 3, 4, 5, 6) with a dynamically adaptable functionality, subject to the detected structure of the control device.

9. Modular electronic control device according to any one of the preceding claims, wherein the module circuitry for performing a pre-defined operation of at least one class of plug-in modules (2, 3, 4, 5, 6) is configurable, wherein the type of each plug-in module of that class is defined by a respective configuration of the plug-in module.

10. Modular electronic control device according to, wherein at least one class of plug-in modules (2, 3, 4, 5, 6) comprises a data memory, wherein the type of each plug-in module of that class is defined by at least one of a kind, a size and a purpose of the data memory.

11. Modular electronic control device according to any one of the preceding claims, comprising one class of plug-in modules (6) for each of the following kinds of operations: digital input, digital output, analogue input, analogue output, wherein each of the classes comprises plug-in modules of one or more types, the respective type depending on an operation of the plug-in module.

12. Modular electronic control device according to claim 11, wherein a functional block for digital input supports signal conditioning and diagnostic for digital and pulse width modulated inputs;
wherein a functional block for analogue input provides signal conditioning and diagnostic for analogue inputs;
wherein a functional block for analogue output provides driving capability and diagnostic for analogue load outputs; and
wherein a functional block for digital output supports at least one of the following digital outputs: high side, low side, half bridge, full bridge and pulse width modulation, and provides respective driving capabilities and diagnostic.

13. Modular electronic control device according to any one of the preceding claims, wherein another class of plug-in modules consists of power supply unit plug-in modules (4) comprising at least one DC-DC converter for transferring energy from a main power source to the plug-in modules (2, 3, 5, 6), and wherein
yet another class of plug-in modules consists of monitoring plug-in modules (5) comprising at least one functional block for supervising a voltage supply status and quality and monitoring for correct operation of the control device, in particular via a watchdog circuit being adapted to generate a reset if a monitored signal is out of an expected operational range.

14. Method of operating a modular electronic control device according to one of the preceding claims, wherein the plurality of plug-in modules (2, 3, 4, 5, 6) is detachably mounted to the main circuit board (1) via the module connectors (14), wherein each plug-in module sends its unique identifier (18) via the internal interface (8) for exchanging signals to the controller plug-in module (2), wherein the controller plug-in module reads the identifiers of each connected plug-in module and determines a structure of the control device from the classes, the types and the number of plug-in modules connected to the main circuit board (1).

15. Method according to claim 14, wherein the controller plug-in module (2) adapts an operating mode of the control device depending on the determined structure of the control device, the operating mode including at least one of an internal communication mode between the plug-in modules and an input/output functionality of the control device.
